# EUROPÄISCHE PATENTSCHRIFT

(11) **EP 0 782 818 B1**
(45) Veröffentlichungstag und Bekanntmachung des Hinweises auf die Patenterteilung: **09.06.1999**
(21) Anmeldenummer: 95931937.7
(22) Anmeldetag: 28.08.1995
(51) Int. Cl.: H05K 5/00

(54) **RASTVERBINDUNG VON GEHÄUSETEILEN MIT INTEGRIERTEM SICHERUNGSSTIFT**
SNAP-IN CONNECTION OF HOUSING SECTIONS WITH INTEGRAL LOCKING PIN
SYSTEME D'ASSEMBLAGE PAR ENCLIQUETAGE POUR ELEMENTS D'UN BOITIER A DOIGT DE BLOCAGE INTEGRE

(30) Priorität: 02.09.1994 DE 4431281
(43) Veröffentlichungstag der Anmeldung: 09.07.1997
(73) Patentinhaber: ITT Automotive Europe GmbH, 60488 Frankfurt am Main (DE)
(72) Erfinder: HECHT, Walter, D-74321 Bietigheim-Bissingen (DE); ENGELHARDT, Martin, D-74189 Weinsberg (DE); KLEIN, Rudolf, D-74348 Lauffen (DE)
(74) Vertreter: Dreiss, Fuhlendorf, Steimle & Becker
(86) Internationale Anmeldenummer: EP9503387
(87) Internationale Veröffentlichungsnummer: WO9608128

(56) Entgegenhaltungen:
- DE-A- 3 335 665
- DE-A- 3 427 936
- DE-U- 9 201 258

## Beschreibung

Die Erfindung betrifft eine Rastverbindung zwischen mindestens zwei Gehäuseteilen, bei der ein federnder Rastarm des einen Gehäuseteiles in eine entsprechende Rastausnehmung des anderen Gehäuseteiles beim Zusammenfügen der Gehäuseteile eingreift. Dabei wird der Rastarm während des Zusammenfügens der Gehäuseteile federnd ausgelenkt, bis er schließlich in der Endstellung der beiden Gehäuseteile zueinander in eine zugeordnete Rastausnehmung eingreift und mit einer Rastnase eine Wand dieser Ausnehmung hintergreift. Im Prinzip können dabei Ausnehmung und Rastnase vertauscht sein.

Nachteilig bei derartigen Verbindungen ist es, daß einerseits die Gehäusewände möglichst dünn und zum leichten Zusammenbau der Rastarm möglichst federnd ausgestaltet werden soll. Andererseits kann durch erhebliche zwischen den Gehäuseteilen wirkenden Kräfte der Rastarm aufgebogen und somit die beiden Gehäuseteile unfreiwillig voneinander getrennt werden. Vielfach ist es auch erwünscht, daß die Kräfte zum Trennen der beiden Gehäuseteile nicht sonderlich groß sind um im Bedarfsfalle das Gehäuse ohne zusätzliche Hilfsmittel leicht öffnen zu können.

Aus der DE-OS 3335665 ist es bekannt, eine Rastverbindung zwischen zwei Gehäuseteilen durch ein Sicherungselement zu sichern, welches sich gegen eines der Rastelemente derart legt, daß es dieses Element entgegen einer in Öffnungsrichtung wirkenden Kraft in seinem Sperrzustand hält.
Dieses Sicherungselement wird nach dem Einrastvorgang zur Sicherung des Rastzustandes in das Gehäuse eingeschoben.

Aus der DE-PS 3427936 ist weiterhin ein Sicherungselement bekannt, welches ebenfalls ein Rastelement einer Rastverbindung zwischen den beiden Gehäuseteilen entgegen einer die Rastverbindung lösenden Bewegungsrichtung des Rastelementes sichert. Dabei stützt sich das Rastelement im Sicherungszustand an einer der Wände eines Gehäuseteils ab. Bei den aus dem Stand der Technik bekannten Sicherungsstiften müssen diese zu einem geeigneten Zeitpunkt in eine entsprechende Gehäuseöffnung eingefädelt werden, was maschinell nur unter erheblichem Aufwand durchführbar ist.

Die Erfindung geht daher aus von einer Rastverbindung der sich aus dem Oberbegriff des Anspruchs 1 ergebenden Gattung. Aufgabe der Erfindung ist es, den Sicherungsstift vor der Montage des Gehäuses in einer für die Montage des Sicherungsstiftes geeigneten Lage zu halten, so daß er ohne Schwierigkeiten nach dem Verrasten der Gehäuseteile in die zugeordnete Gehäuseöffnung eingefügt werden kann.

Die Aufgabe wird durch die sich aus dem kennzeichnenden Teil des Anspruchs 1 ergebende Merkmalskombination gelöst.

Danach ist der Sicherungsstift in Einbaurichtung ausgerichtet einstückig mit einem der Gehäuseteile verbunden. Er steht also während des Zusammenbaus der beiden Gehäuseteile ohne weiteres zur Verfügung.

Eine besonders einfache Montage des Sicherungsstiftes ergibt sich durch Anwendung der Merkmalskombination nach Anspruch 2. Danach wird der Boden der Kammer durch einen Sicherungsstift gebildet, der mit dem zugehörigen Gehäuseteil einstückig verbunden ist. Der Sicherungsstift kann leicht aus dem Kammerboden herausgebrochen werden oder kann auch als leicht herausbrechbarer Kammerboden selbst betrachtet werden.

Danach ist es nur notwendig eine hinreichend große Kraft in Längsrichtung des Sicherungsstiftes, gerichtet zur Kammer hin auszuüben um den Sicherungsstift in die Kammer hineinzustoßen und in seine Sicherungslage zu bringen. Die Befestigung des Sicherungsstiftes am Gehäuseteil sollte dabei so leicht auftrennbar sein, daß beim Herausbrechen des Stiftes keine Beschädigungen an den übrigen Gehäuseteilen des Schaltergehäuses auftreten können.

Ein besonders einfacher Aufbau ergibt sich durch die Verwendung der Merkmale nach Anspruch 3. Dabei sind Kammerwände, Rastfeder und Stift einstückig an eines der beiden Gehäuseteile angegossen.

Der Aufbau wird hinsichtlich des Stiftes und der Kammer durch die Merkmale nach Anspruch 4 erleichter in dem sowohl Kammer als auch Stift senkrecht bzw. parallel zueinander stehende Flächen bzw. Wände aufweisen.

Um gleichzeitig zu erreichen, daß der Stift hinreichend sicher in der Kammer gehalten wird empfiehlt sich die Verwendung der Merkmale nach Anspruch 5 da sich so hinreichend leicht eine gute Klemmverbindung des Stiftes in der Kammer erreichen läßt.

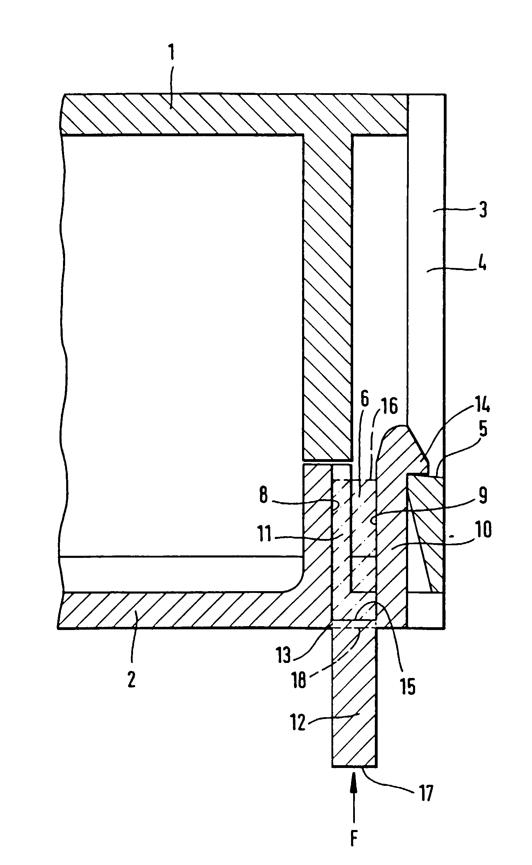

Ein Ausführungsbeispiel der Erfindung wird nachfolgend anhand der Zeichnung erläutert.

Die Zeichnung zeigt ein erstes Gehäuseteil 1 und ein zweites Gehäuseteil 2 wobei das erste Gehäuseteil 1 beispielsweise der Deckel eines Schaltergehäuses und das zweite Gehäuse 2 die Grundplatte eines Schaltergehäuses sein kann. Die Außenwand 3 des Gehäusedeckes 1 besitzt eine Ausnehmung 4 die an ihrem unteren Ende durch eine Begrenzungswand 5 übergeht.

Der Boden des Gehäuseteiles 2 besitzt eine zum Gehäuseinneren hin offene Kammer 6, wobei auch die verbleibenden Kammerwände 8, 9, 11 teilweise ausgespart sind. Die erste Kammerwand 8 wird durch einen in das Gehäuseinnere ragenden Vorsprung 19 gebildet. Der ersten Kammerwand liegt eine zweite Kammerwand 9 gegenüber, die durch die Rückwand einer Rastfeder 10 gebildet ist. Die Rastfeder 10 selbst ist ein an den Gehäuseboden angegossener Kunststoffansatz und trägt an ihrem in der Zeichnung oberen Ende eine Rastnase 14, welche im zusammengebauten Zustand der beiden Gehäuseteile 1, 2 die Begrenzungswand 5 hintergreift. Von den beiden seitlichen Kammerwänden ist nur die dritte Kammerwand 11 zu erkennen, die sich nicht über die gesamte Kammerbreite erstreckt, während die zweite Seitenwand der Kammer 6 aufgrund der Schnittführung in der Figur nicht zu erkennen ist. Der Boden der Kammer 6 geht über in einen senkrecht vom Gehäuseboden abstehenden Sicherungsstift 12. Die Verbindung zwischen Stift 12 und Boden des Gehäuses ist vergleichsweise dünn. Bei dem vorliegenden Beispiel bilden der Boden der Kammer 6 und der Stift 12 eine Einheit.

Wichtig ist, daß die Verbindung zwischen Stift 12 und Gehäuseboden 2 mechanisch nicht sehr fest ist und damit leicht aufgetrennt werden kann. In der Zeichnung ist dies die gedachte umlaufende Fläche 13. Übt man nun ein hinreichend große Kraft in Richtung des Pfeiles F auf den Sicherungsstift 12 aus, so wird die Verbindung zwischen Gehäuseboden und Sicherungsstift zerreißen und der Sicherungsstift 12 kann in den Innenraum der Kammer 6 eingeschoben werden. Dabei wandert die erste Stirnfläche 15 zu der gestrichelten Linie 16 und die zweite Stirnfläche 17 zu der gestrichelten Linie 18. Der Sicherungsstift 12 füllt in diesem Sicherungszustand nunmehr die Kammer 6 weitgehend aus.

Wenn nun aufgrund einer Kraft zwischen den beiden Gehäuseteilen der als Rastfeder dienende Ansatz 10 in der Figur nach links ausschwenken, so wird diese Kraft über den Stift auf die erste Kammerwand 8 übertragen, die eine derartige Bewegung der Rastfeder nicht zuläßt. Damit sind die beiden Gehäuseteile 1, 2 miteinander verriegelt. Um eine Entriegelung zu ermöglichen muß der Stift 12 entgegen der Richtung F aus der Kammer 6 herausgezogen werden.

## Patentansprüche

1. Rastverbindung zwischen zwei Gehäuseteilen (1,2) insbesondere einem Gehäusedeckel mit einem Gehäuseboden eines Schaltergehäuses mittels einer einstückig mit einem der Gehäuseteile verbundenen Rastfeder (10) die mit dem anderen Gehäuseteil (1) eine Rastverbindung schafft, wobei die Gehäuseteile (1,2) vorzugsweise Teile eines Schaltergehäuses sind, wobei das Gehäuse zumindest im zusammengebauten Zustand eine Kammer (6) bildet, bei der zumindest ein Teil einer Seitenwand durch die Rastfeder (10) gebildet ist, und daß im verrasteten Zustand des Gehäuses ein Sicherungsstift (12) in die Kammer (6) eingefügt ist, welcher ein Ausschwenken der Rastfeder (10) im Sinne einer Entrastung verhindert und damit die Gehäuseverbindung sichert, dadurch **gekennzeichnet,** daß vor der Montage des Sicherungsstiftes (12) dieser in Höhe des Kammerbodens von einem der Gehäuseteile (2) vorzugsweise senkrecht absteht und mit diesem heraustrennbar einstückig verbunden ist.

2. Rastverbindung nach Anspruche 1, dadurch **gekennzeichnet,** daß der Kammerboden durch die Stirnfläche des Stiftes gebildet ist und daß die einstückige Verbindung zwischen Stift und zugehörigem Gehäuseteil so dünn gewählt ist, daß der Stift (12) in die Kammer (6) durch Zerreißen einer Sollbruchstelle eindrückbar ist, ohne die verbleibenden Teile des Gehäuses (1, 2) zu beschädigen.

3. Rastverbindung nach einem der vorhergehenden Ansprüche, dadurch **gekennzeichnet,** daß die Kammerwände (8,9,11), die Rastfeder (10) und der Stift (12) einstückig an dem Gehäuseboden des Gehäuseteils (2) angeformt sind.

4. Rastverbindung nach einem der vorhergehenden Ansprüche, dadurch **gekennzeichnet**, daß der Stift (12) und die Kammer (6) im wesentlichen Quaderförmig sind.

5. Rastverbindung nach einem der vorhergehenden Ansprüche, dadurch **gekennzeichnet**, daß der Stift (12) zum Schalterboden hin sich keilförmig verjüngt.

## Claims

1. Snap-in connection between two housing sections (1, 2), in particular a housing cover and a housing base of a switch housing by means of a snap-in spring (10) which is integrally connected to one of the housing sections and which creates a snap-in connection with the other housing section (1), wherein the housing sections (1, 2) are preferably sections of a switch housing, wherein the housing forms, at least in the assembled state, a chamber (6) in which at least a part of one side wall is formed by the snap-in spring (10) and wherein, in the snapped-in state of the housing, there is inserted into the chamber (6) a locking pin (12) which prevents a swinging of the snap-in spring (10) for the purpose of unlocking and consequently secures the housing connection, characterized in that, prior to the assembly of the locking pin (12), the latter preferably projects perpendicularly from one of the housing sections (2) at the level of the chamber base and is integrally joined to the latter in a separable manner.

2. Snap-in connection according to Claim 1, characterized in that the chamber base is formed by the end face of the pin and in that the integral connection between pin and associated housing section is chosen to be so thin that the pin (12) can be pressed into the chamber (6) by rupturing a predetermined breakpoint without damaging the remaining sections of the housing (1, 2).

3. Snap-in connection according to one of the preceding claims, characterized in that the chamber walls (8, 9, 11), the snap-in spring (10) and the pin (12) are integrally moulded onto the housing base of the housing section (2).

4. Snap-in connection according to one of the preceding claims, characterized in that the pin (12) and the chamber (6) are substantially of parallelepiped shape.

5. Snap-in connection according to one of the preceding claims, characterized in that the pin (12) tapers in a wedged-shaped manner towards the switch base.

## Revendications

1. Assemblage par encliquetage entre deux parties de boîtier (1, 2), en particulier entre un couvercle et un fond d'un boîtier d'interrupteur, au moyen d'un ressort d'encliquetage (10), relié d'une seule pièce à l'une des parties de boîtier, qui réalise un assemblage par encliquetage avec l'autre partie de boîtier (1), les parties de boîtier (1, 2) étant de préférence des parties d'un boîtier d'interrupteur, le boîtier formant, au moins à l'état assemblé, une chambre (6) dans laquelle au moins une partie d'une paroi latérale est formée par le ressort d'encliquetage (10), et à l'état encliqueté du boîtier, une goupille de sûreté (12) étant insérée dans la chambre (6) et empêchant un pivotement du ressort d'encliquetage (10) dans le sens d'un déverrouillage et bloquant ainsi l'assemblage du boîtier, caractérisé en ce qu'avant le montage de la goupille de sûreté (12) celle-ci dépasse, de préférence perpendiculairement, au niveau du fond de la chambre de l'une des parties de boîtier (2) et est reliée d'une seule pièce avec celle-ci de manière à pouvoir en être séparée.

2. Assemblage par encliquetage selon la revendication 1, caractérisé en ce que le fond de la chambre est formé par la face frontale de la goupille et en ce que la liaison d'une seule pièce entre la goupille et la partie de boîtier correspondante est choisie si mince que la goupille (12) peut être enfoncée dans la chambre (6) par arrachement d'un emplacement destiné à la rupture, sans endommager les parties restantes du boîtier (1, 2).

3. Assemblage par encliquetage selon l'une des revendications précédentes, caractérisé en ce que les parois (8, 9, 11) de la chambre, le ressort d'encliquetage (10) et la goupille (12) sont formés d'une seule pièce sur le fond de la partie de boîtier (2).

4. Assemblage par encliquetage selon l'une des revendications précédentes, caractérisé en ce que la goupille (12) et la chambre (6) sont sensiblement de forme parallélépipédique.

5. Assemblage par encliquetage selon l'une des revendications précédentes, caractérisé en ce que la goupille (12) se rétrécit en forme de coin vers le fond de l'interrupteur.
